(19) Europäisches Patentamt / European Patent Office / Office européen des brevets

(11) **EP 2 917 649 B1**

(12) **EUROPEAN PATENT SPECIFICATION**

(45) Date of publication and mention
of the grant of the patent:
**13.09.2017 Bulletin 2017/37**

(21) Application number: **13782881.0**

(22) Date of filing: **04.10.2013**

(51) Int Cl.:
*F24F 5/00* (2006.01)    *F25B 41/04* (2006.01)
*F25B 49/02* (2006.01)    *F24F 11/00* (2006.01)
*H05K 7/20* (2006.01)

(86) International application number:
**PCT/US2013/063531**

(87) International publication number:
**WO 2014/055914 (10.04.2014 Gazette 2014/15)**

(54) **LOAD ESTIMATOR FOR CONTROL OF VAPOR COMPRESSION COOLING SYSTEM WITH PUMPED REFRIGERANT ECONOMIZATION**

BELADUNGSMESSGERÄT ZUR STEUERUNG EINES DAMPFKOMPRESSIONSKÜHLSYSTEMS MIT RATIONALISIERUNG EINES GEPUMPTEN KÄLTEMITTELS

ESTIMATEUR DE CHARGE À DES FINS DE COMMANDE D'UN SYSTÈME DE REFROIDISSEMENT À COMPRESSION DE VAPEUR AVEC ÉCONOMIE DE FRIGORIGÈNE POMPÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.10.2012 US 201261710138 P**

(43) Date of publication of application:
**16.09.2015 Bulletin 2015/38**

(73) Proprietor: **Liebert Corporation**
**Columbus, OH 43085 (US)**

(72) Inventors:
• **LU, Zongtao**
**Pittsburgh, Pennsylvania 15238 (US)**
• **HAGGY, Greg**
**Gahanna, Ohio 43230 (US)**
• **SCHRADER, Timothy J.**
**Irwin, Ohio 43029 (US)**
• **SILLATO, Stephen**
**Westerville, Ohio 43081 (US)**
• **JUDGE, John F.**
**Galena, Ohio 43021 (US)**

(74) Representative: **Bryn-Jacobsen, Caelia et al**
**Kilburn & Strode LLP**
**20 Red Lion Street**
**London WC1R 4PJ (GB)**

(56) References cited:
**EP-A1- 2 389 056       WO-A1-03/083631**
**US-A1- 2010 107 658**

## Description

The present disclosure relates to cooling systems, and more particularly, to high efficiency cooling systems.

BACKGROUND

This section provides background information related to the present disclosure which is not necessarily prior art.

Cooling systems have applicability in a number of different applications where fluid is to be cooled. They are used in cooling gas, such as air, and liquids, such as water. Two common examples are building HVAC (heating, ventilation, air conditioning) systems that are used for "comfort cooling," that is, to cool spaces where people are present such as offices, and data center climate control systems.

A data center is a room containing a collection of electronic equipment, such as computer servers. Data centers and the equipment contained therein typically have optimal environmental operating conditions, temperature and humidity in particular. Cooling systems used for data centers typically include climate control systems, usually implemented as part the control for the cooling system, to maintain the proper temperature and humidity in the data center.

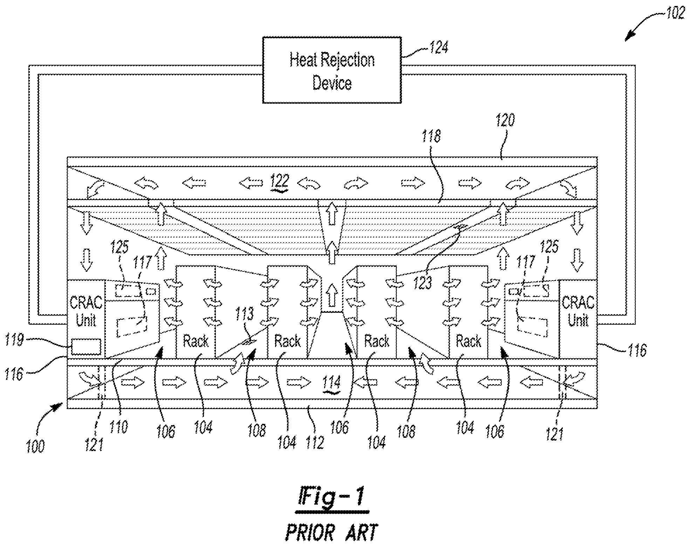

Fig. 1 shows an example of a typical data center 100 having a climate control system 102 (also known as a cooling system). Data center 100 illustratively utilizes the "hot" and "cold" aisle approach where equipment racks 104 are arranged to create hot aisles 106 and cold aisles 108. Data center 100 is also illustratively a raised floor data center having a raised floor 110 above a sub-floor 112. The space between raised floor 110 and sub-floor 112 provides a supply air plenum 114 for conditioned supply air (sometimes referred to as "cold" air) flowing from computer room air conditioners ("CRACs") 116 of climate control system 102 up through raised floor 110 into data center 100. The conditioned supply air then flows into the fronts of equipment racks 104, through the equipment (not shown) mounted in the equipment racks where it cools the equipment, and the hot air is then exhausted out through the backs of equipment racks 104, or the tops of racks 104. In variations, the conditioned supply air flows into bottoms of the racks and is exhausted out of the backs of the racks 104 or the tops of the racks 104.

It should be understood that data center 100 may not have a raised floor 110 nor plenum 114. In this case, the CRAC's 116 would draw in through an air inlet (not shown) heated air from the data center, cool it, and exhaust it from an air outlet 117 shown in phantom in Fig. 1 back into the data center. The CRACS 116 may, for example, be arranged in the rows of the electronic equipment, may be disposed with their cool air supply facing respective cold aisles, or be disposed along walls of the data center.

In the example data center 100 shown in Fig. 1, data center 100 has a dropped ceiling 118 where the space between dropped ceiling 118 and ceiling 120 provides a hot air plenum 122 into which the hot air exhausted from equipment racks 104 is drawn and through which the hot air flows back to CRACs 116. A return air plenum (not shown) for each CRAC 116 couples that CRAC 116 to plenum 122.

CRACs 116 may be chilled water CRACs or direct expansion (DX) CRACs. CRACs 116 are coupled to a heat rejection device 124 that provides cooled liquid to CRACs 116. Heat rejection device 124 is a device that transfers heat from the return fluid from CRACs 116 to a cooler medium, such as outside ambient air. Heat rejection device 124 may include air or liquid cooled heat exchangers. Heat rejection device 124 may also be a refrigeration condenser system, in which case a refrigerant is provided to CRACs 116 and CRACs 116 may be phase change refrigerant air conditioning systems having refrigerant compressors, such as a DX system. Each CRAC 116 may include a control module 125 that controls the CRAC 116.

In an aspect, CRAC 116 includes a variable capacity compressor and may for example include a variable capacity compressor for each DX cooling circuit of CRAC 116. It should be understood that CRAC 116 may, as is often the case, have multiple DX cooling circuits. In an aspect, CRAC 116 includes a capacity modulated type of compressor or a 4-step semi-hermetic compressor, such as those available from Emerson Climate Technologies, Liebert Corporation or the Carlyle division of United Technologies. CRAC 116 may also include one or more air moving units 119, such as fans or blowers. The air moving units 119 may be provided in CRACs 116 or may additionally or alternatively be provided in supply air plenum 114 as shown in phantom at 121. Air moving units 119, 121 may illustratively have variable speed drives.

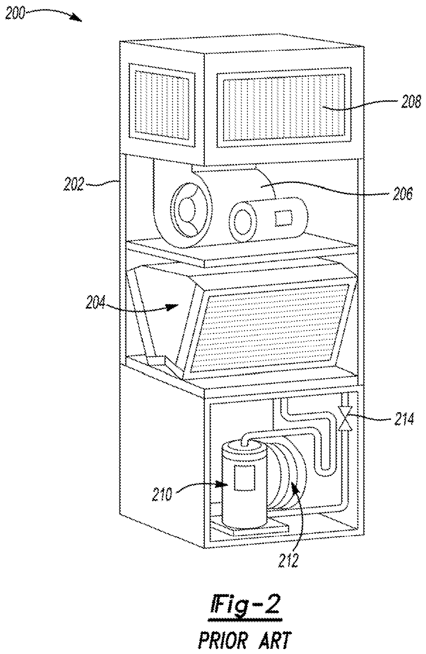

A typical CRAC 200 having a typical DX cooling circuit is shown in Fig. 2. CRAC 200 has a cabinet 202 in which an evaporator 204 is disposed. Evaporator 204 may be a V-coil assembly. An air moving unit 206, such as a fan or squirrel cage blower, is also disposed in cabinet 202 and situated to draw air through evaporator 204 from an inlet (not shown) of cabinet 202, where it is cooled by evaporator 204, and direct the cooled air out of plenum 208. Evaporator 204, a compressor 210, a condenser 212 and an expansion valve 214 are coupled together in known fashion in a DX refrigeration circuit. A phase change refrigerant is circulated by compressor 210 through condenser 212, expansion valve 214, evaporator 204 and back to compressor 210. Condenser 212 may be any of a variety of types of condensers conventionally used in cooling systems, such as an air cooled condenser, a water cooled condenser, or glycol cooled condenser. It should be understood that condenser 210 is often not part of the CRAC but is located elsewhere, such as outside the building in which the CRAC is located. Compressor 210 may be any of a variety of types of compressors conventionally used in DX refrigeration systems, such as a scroll compressor. When evaporator 204 is a V-coil or A-coil assembly, it typically has a cooling slab (or slabs) on each leg of the V or A, as applicable. Each cooling slab may, for example, be in a separate cooling circuit with each cooling circuit having a separate compressor. Alternatively, the fluid circuits in each slab such as where there are two slabs and two compressor circuits, can be intermingled among the two compressor circuits.

Evaporator 204 is typically a fin-and-tube assembly and is used to both cool and dehumidify the air passing through them. Typically, CRAC's such as CRAC 200 are designed so that the sensible heat ratio ("SHR") is typically between .85 and .95.

A system known as the GLYCOOL free-cooling system is available from Liebert Corporation of Columbus, Ohio. In this system, a second cooling coil assembly, known as a "free cooling coil," is added to a CRAC having a normal glycol system. This second coil assembly is added in the air stream ahead of the first cooling coil assembly. During colder months, the glycol solution returning from the outdoor drycooler is routed to the second cooling coil assembly and becomes the primary source of cooling to the data center. At ambient temperatures below 35 deg. F, the cooling capacity of the second cooling coil assembly is sufficient to handle the total cooling needs of the data center and substantially reduces energy costs since the compressor of the CRAC need not be run. The second or free cooling coil assembly does not provide 100% sensible cooling and has an airside pressure drop similar to the evaporator (which is the first cooling coil assembly).

Efficiency of cooling systems has taken on increased importance. According to the U.S. Department of Energy, cooling and power conversion systems for data centers consume at least half the power used in a typical data center. In other words, less than half the power is consumed by the servers in the data center. This has led to increased focus on energy efficiency in data center cooling systems.

SUMMARY

In accordance with an aspect of the present disclosure, a cooling system includes a cabinet having an air inlet and an air outlet and a cooling circuit that includes an evaporator disposed in the cabinet, a condenser, a compressor, an expansion device and a liquid pump. The cooling system has a direct expansion mode wherein the compressor is on and compresses a refrigerant in a vapor phase to raise its pressure and thus its condensing temperature and refrigerant is circulated around the cooling circuit by the compressor. The cooling system also has a pumped refrigerant economizer mode wherein the compressor is off and the liquid pump is on and pumps the refrigerant in a liquid phase and refrigerant is circulated around the cooling circuit by the liquid pump and without compressing the refrigerant in its vapor phase. In an aspect, the cooling system has a controller coupled to the liquid pump and the compressor that turns the compressor off and the liquid pump on to operate the cooling circuit in the economizer mode and turns the compressor on to operate the cooling circuit in the direct expansion mode. In an aspect, the controller includes a load estimator that estimates real-time indoor load on the cooling system and uses the estimated real-time indoor load to determine whether to operate the cooling system in the pumped refrigerant economizer mode or in the direct expansion mode.

In an aspect, the load estimator calculates the real-time indoor load based on the indoor return air temperature, the supply air temperature and the volume of air flow across the evaporator. In an aspect, if supply air temperature is not available, the load estimator uses compressor loading information instead.

In an aspect, the cooling circuit includes a receiver/surge tank coupled between the condenser and the liquid pump.

In an aspect, the cooling system includes a plurality of cooling circuits with each cooling circuit included in one of a plurality of cooling stages including an upstream cooling stage and a downstream cooling stage wherein the evaporator of the cooling circuit of the upstream cooling stage (upstream evaporator) and the evaporator of the cooling circuit of the downstream cooling stage (downstream evaporator) are arranged in the cabinet so that air to be cooled passes over them in serial fashion, first over the upstream evaporator and then over the downstream evaporators. The cooling circuit of each cooling stage has the direct expansion mode wherein the compressor of that cooling circuit is on and the refrigerant is circulated around the cooling circuit by the compressor of that cooling circuit and a pumped refrigerant economizer mode wherein the compressor of that cooling circuit is off and the liquid pump of that cooling circuit is on and the refrigerant is circulated around the cooling circuit by the liquid pump of that cooling circuit. In an aspect, when one of the upstream and downstream cooling stages can be in the economizer mode and the other must be in the direct expansion mode, the controller operates the cooling circuit of the upstream cooling stage in the economizer mode turning the liquid pump of that cooling circuit on and the compressor of that cooling circuit off and operates the downstream cooling stage in the direct expansion mode turning the compressor of the downstream cooling circuit on.

EP2389056 relates to a computer room air conditioner ("CRAC") with a cabinet having an air inlet through which return air from an area is drawn and an air outlet through which air cooled by the CRAC is exhausted. An air moving unit is disposed in the cabinet as are a plurality of cooling coils, which are in separate cooling circuits. The cooling coils are arranged so that the air passes through the cooling coils in serial fashion, that is, first through an upstream cooling coil and then through a downstream cooling cool. The upstream cooling coil acts as a pre-cooler to the subsequent downstream cooling coil. The CRAC includes a controller that controls the cooling provided by the cooling circuits. The controller controls the cooling provided by the upstream cooling circuit so that when it is being used to provide cooling, it provides only sensible cooling.

The present invention is set out in the independent claims, with some optional features set out in the claims dependent thereto.

DRAWINGS

The drawings described herein are for illustrative purposes only of selected embodiments and not all possible implementations, and are not intended to limit the scope of the present disclosure.

Fig. 1 is a schematic illustrating a prior art data center;
Fig. 2 is a simplified perspective view of a prior art CRAC having a DX cooling circuit;
Fig. 3 is a schematic showing a CRAC having staged cooling provided by two cooling circuits;
Fig. 4 is a simplified perspective view of a CRAC having the cooling circuits of the CRAC of Fig. 3;
Fig. 5 is a cooling system having a DX cooling circuit with a pumped refrigerant economizer;
Figs. 6, 7A and 7B are variations of the cooling system of Fig. 5;
Fig. 8 is a schematic showing a cooling system having staged cooling provided by two cooling circuits of Fig. 5;
Fig. 9 is a schematic showing the cooling system of Fig. 5 and showing in more detail the control system therewith;
Fig. 10 shows control loops for the control system of Fig. 9; and
Fig. 11 is a flow chart showing an illustrative control of a cooling system utilizing a load estimator in accordance with an aspect of the present disclosure.

Corresponding reference numerals indicate corresponding parts throughout the several views of the drawings.

DETAILED DESCRIPTION

Example embodiments will now be described more fully with reference to the accompanying drawings.

In accordance with an aspect of the present disclosure, a high efficiency cooling system includes staged cooling provided by two or more cooling circuits arranged so that air to be cooled flows through them serially. In an aspect, each cooling circuit includes a tandem digital scroll compressor made up of a fixed capacity scroll compressor and digital scroll compressor. It should be understood that instead of tandem digital compressors, a plurality of compressors can be plumbed in parallel and these compressors may have differing capacities. In an aspect, each cooling circuit includes a DX cooling circuit and a pumped refrigerant economization circuit that bypasses the compressor when the outdoor temperature is sufficiently low to provide the requisite cooling to the refrigerant being circulating in the cooling circuit. In an aspect, the high efficiency cooling system also includes one or more fans, blowers or similar air moving units that move air to be cooled through the evaporators of each cooling circuit. The motors of the air moving unit may illustratively be variable speed motors, and may illustratively be electronically controlled motors. The same may be the case for the fan motors for the condenser. In an aspect, the cooling circuits of the high efficiency cooling system include an electronic expansion valve.

It should be understood that a cooling system can have less than all these elements, and can have various combinations of them. For example, the cooling system may not have staged cooling but have a cooling circuit that includes a DX cooling circuit and the pumped refrigerant economization circuit. In this aspect, the tandem digital scroll may or may not be utilized.

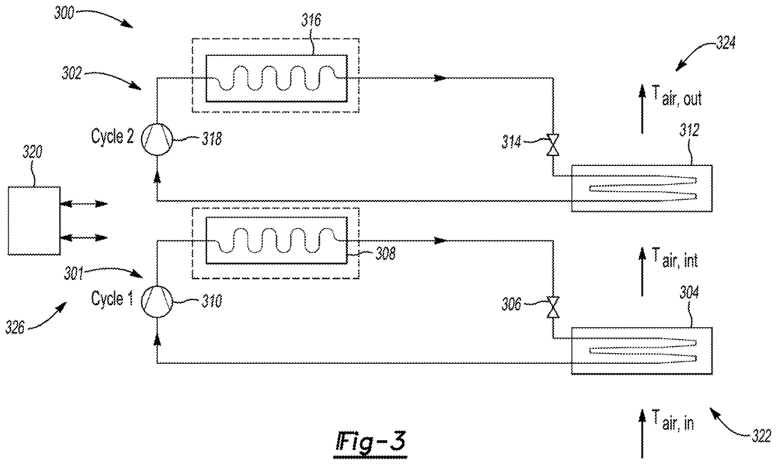

Fig. 3 is a simplified schematic of a cooling system 300 having a plurality of cooling stages including an upstream cooling stage 322 with an upstream cooling circuit 301 and a downstream cooling stage 324 with a downstream cooling circuit 302 in accordance with an aspect of the present disclosure. In the embodiment of Fig. 3, cooling circuits 301, 302 are both DX refrigeration circuits. Upstream cooling circuit 301 includes an evaporator referred to as upstream evaporator 304, expansion valve 306, condenser 308 and compressor 310 arranged in a conventional DX refrigeration circuit. Downstream cooling circuit 302 includes an evaporator referred to as downstream evaporator 312, expansion valve 314, condenser 316 and compressor 318 arranged in a conventional DX refrigeration circuit. In this regard, evaporator 304, expansion valve 306 and compressor 310 of upstream cooling circuit 301 and evaporator 312, expansion valve 314 and compressor 318 of downstream cooling circuit 302 may all be included in a CRAC 326 located in a data center along with controller 320. Condensers 308, 316 are shown in dashed boxes as they are typically not included in CRAC 326 but located elsewhere, such as outside the building in which CRAC 326 is located. Expansion valves 306, 314 may preferably be electronic expansion valves, but may also be thermostatic expansion valves such as those disclosed in U.S. 4,606,198. In each DX refrigeration circuit 301, 302, a refrigerant is circulated by the compressor and it flows from the compressor, through the condenser, expansion valve, evaporator and back to the compressor. The evaporators 304, 312 of upstream and downstream cooling circuits 301, 302 are arranged in stages so that air drawn in through an inlet of the CRAC flows in serial fashion through evaporators 304, 312, that is, the air flows first through the upstream evaporator 304 in upstream cooling circuit 301 and then through downstream evaporator 312 in the downstream cooling circuit 302. By having a plurality of cooling stages arranged for serial air flow therethrough, the temperature differential across the evaporators of each DX refrigeration circuit is reduced. This in turn allows the evaporators in each DX refrigeration circuit to operate at different pressure levels and allows the pressure differences between the respective evaporators and condensers to be reduced. Since compressor power is a function of the pressure difference between the evaporator and condenser, a lower pressure difference is more energy efficient. It should be understood that each compressor 310, 318 may include tandem compressors with one compressor a fixed capacity compressor and the other compressor a variable capacity compressor, such as a digital scroll compressor. Each compressor 310, 318 may be a tandem digital scroll compressor that includes a fixed capacity scroll compressor and a digital scroll compressor, as discussed in more detail below.

It should be understood that condensers 308, 316 can be any of the heat rejection devices described above with regard to heat rejection device 124 of Fig. 1.

The cooling circuit of each stage provides a portion of the overall cooling provided by CRAC 326 of cooling system 300. The portions can be equal, with each stage providing equal cooling, or they can be different. More specifically, each cooling stage has a maximum temperature difference that is a portion of the maximum temperature difference across CRAC 326. For example, if CRAC 326 has a maximum temperature difference of 20 deg. F, the cooling circuit of each stage has a maximum temperature difference that is some percentage of 20 deg. F. This may be an equal percentage, in which case cooling circuit 301, 302 each have a maximum 10 deg. F temperature difference where the maximum temperature difference across CRAC 326 is 20 deg. F, or the percentages may be different.

Cooling system includes controller 320 that controls cooling circuits 301, 302.

In an aspect, evaporators 304, 312 may have a plurality of cooling slabs, such as in a V-coil assembly, and instead of having each cooling slab of downstream evaporator 312 be fed by separate compressors, both cooling slabs of downstream evaporator 312 would be fed by a compressor and both cooling slabs of upstream evaporator 304 would be fed by another compressor. These two compressors would preferably have equal capacity and the staged cooling allows the two compressors to be smaller (lesser capacity) than the two compressors used to feed the two cooling slabs of an evaporator in a typical prior art CRAC having DX refrigeration circuits for the two cooling slabs that provide comparable cooling capacity.

In an alternate embodiment, compressor 318 in downstream cooling circuit 302 is larger (that is, has a higher capacity) than compressor 310 in upstream cooling circuit 301 in order to decrease the evaporating temperature of the refrigerant provided to downstream evaporator 312. This in turn decreases the sensible heat ratio and increases the dehumidification capabilities of downstream cooling circuit 302. In this embodiment, downstream evaporator 312 may have the same cooling surface area as that of upstream evaporator 304 in upstream cooling circuit 301, or may have a cooling surface area that is different (larger or smaller) than the surface cooling area of upstream evaporator 304.

In an aspect, upstream evaporator 304 in upstream cooling circuit 301 is a microchannel cooling coil assembly. Upstream evaporator 304 may illustratively be a microchannel heat exchanger of the type described in USSN 12/388,102 filed February 18, 2009 for "Laminated Manifold for Microchannel Heat Exchanger" the entire disclosure of which is incorporated herein by reference. Upstream evaporator 304 may illustratively be a MCHX microchannel heat exchanger available from Liebert Corporation of Columbus, Ohio. When upstream evaporator 304 is a micro-channel heat exchanger, upstream cooling circuit 301 is illustratively configured to provide sensible only cooling, such as providing a temperature delta across upstream evaporator 304 that does not drop the temperature of the air exiting upstream evaporator 304 below its dewpoint, or below a temperature a certain number of degrees above the dewpoint, such as about 4 deg. F. While one advantage of using a microchannel cooling coil assembly for upstream evaporator 304 of upstream cooling circuit 301 is that microchannel cooling coil assemblies have air side pressure drops across them that are significantly less than fin-and-tube cooling coil assemblies having comparable cooling capacity, it should be understood that upstream evaporator 304 can be other than a microchannel cooling coil, and may for example be a fin-and-tube cooling coil assembly.

In an aspect, downstream evaporator 312 of downstream cooling circuit 302 is a fin-and-tube cooling coil assembly. In an aspect, downstream evaporator 312 is a microchannel cooling coil assembly.

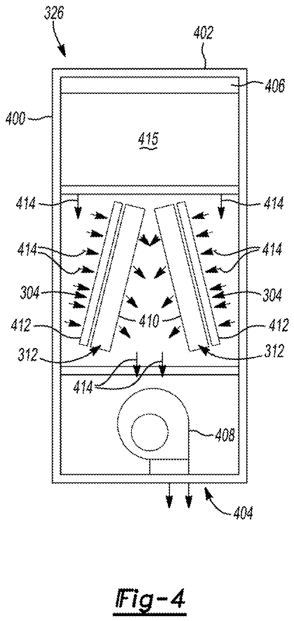

Fig. 4 shows an illustrative embodiment of CRAC 326. CRAC 326 includes a cabinet 400 having a return air inlet 402 and an air outlet 404, such as a plenum. An air filter 406 is disposed at return air inlet 402 so that air flowing into CRAC 326 through return air inlet 402 flows through air filter 406 before flowing through the rest of CRAC 326. Arrows 414 show the direction of air flow through CRAC 326.

In the embodiment shown in Fig. 4, downstream evaporator 312 of downstream cooling circuit 302 is an A-coil assembly disposed in cabinet 400 between return air inlet 402 and air outlet 404. Downstream evaporator 312 thus has a cooling slab 410 for each leg of the A. Upstream evaporator 304 is also an A-coil assembly having a cooling slab 412 for each leg of the A. An air moving unit 408, such as a fan or squirrel cage blower, is disposed in cabinet 400 between a downstream side of downstream evaporator 312 and air outlet 404. One of the cooling slabs 412 of upstream evaporator 304 is disposed on the air inlet side of one of the cooling slabs 410 of downstream evaporator 312 and the other of the cooling slabs 412 of upstream evaporator 304 is disposed on the air inlet side of the other of the cooling slabs 410 of downstream evaporator 312. The cooling slabs 410 of downstream evaporator 312 and the cooling slabs 412 of upstream evaporator 304 are thus arranged in pairs, with respective ones of the cooling slabs 412 of upstream evaporator paired with respective ones of the cooling slabs 410 of downstream evaporator 312. In should be understood that air moving unit 408 may alternatively be disposed upstream of upstream evaporator 304.

While the downstream evaporator discussed above was a A-coil assembly, and in an aspect the upstream evaporator discussed above was also a A-coil assembly, it should be understood that the staged cooling system could utilize a V-coil assembly as the downstream evaporator and in an aspect, utilize an V-coil assembly as the upstream evaporator It should also be understood that the upstream and downstream evaporators could each utilize a large, inclined cooling slab, or a flat cooling slab.

In accordance with another aspect of the present disclosure, a cooling system, which may include a CRAC, includes a DX cooling circuit with a pumped refrigerant economizer enabling the system to be run in a pumped refrigerant economizer mode when the temperature outside is cold enough to cool the cooling fluid circulating in the cooling circuit and bypass the compressor. The cooling fluid may illustratively be a phase change refrigerant having a vapor phase and a liquid phase. The pumped refrigerant economizer may illustrativley include a pump that circulates the cooling fluid, illustrataively the refrigerant in its liquid phase, with the compressor byassed. This cooling system then uses the pump instead of the compressor to pump the refrigerant in its liquid phase and circulate the refrigerant when the outside air temperature is low enough to provide the heat exchange without compressing the refrigerant in its vapor phase to a higher pressure/condensing temperature. The economizer mode significantly increases the cooling system's sensible coefficient of performance (COP) when the cooling system switches to the economizer mode as described below. In terms of annual efficiency, the climate determines the benefit. For instance, modeling has shown that the annual energy efficiency increase in Washington DC is about 26%, while in Minneapolis, MN, the annual energy efficiency increase is about 53%.

As discussed above, a conventional DX air conditioning system contains an evaporator, a compressor, a condenser and an expansion device. Often the air being cooled is at a lower temperature than the outside air. Because of this, a compressor is required to raise the pressure of the refrigerant in its vapor phase, and therefore its condensing temperature, to a higher temperature than the outside air so that the heat can be rejected. In any application in which heat is rejected to the outdoors even in the middle of the winter, the need to compress the cooling fluid consumes energy unnecessarily.

When the outdoor temperature becomes low enough to provide the overall required temperature difference between the inside air from which the heat is removed and the outside air to which the heat is rejected, there is no need to compress the refrigerant in its vapor phase to a higher pressure/temperature. When that is the case, the cooling system in accordance with this aspect of the present disclosure switches from DX (compressor) mode to pumped refrigerant economizer mode. In the pumped refrigerant economizer mode, the refrigerant is pumped in its liquid phase by a liquid pump to circulate the refrigerant in the cooling circuit without compressing the refrigerant in its vapor phase. The advantage is that the pump consumes roughly 1/10 of the power consumed by the compressor.

The temperature at which the controller of the cooling system having a pumped refrigerant economizer mode decides to switch from one mode to the other is based on the difference between the indoor and outdoor temperatures, and the heat load on the cooling system. In an aspect, the cooling system described herein includes the components listed above, which are the typical components of a DX cooling circuit described with reference to Fig. 2, as well as a pump. When the controller decides to switch from DX (compressor) mode to pumped refrigerant economizer mode, the compressor is turned off and the pump is turned on. In the pumped refrigerant economizer mode, the refrigerant is bypassed around the compressor, while in DX (compressor) mode, the refrigerant is bypassed around the pump.

The following description of embodiments of a cooling system having a DX cooling circuit and a pumped refrigerant economizer will show alternative system layouts and component functionality. The three main control considerations for this system operating in the pumped refrigerant economizer mode are capacity control, evaporator freeze prevention (outdoor temperature can get very low) and pump protection. Most pumps require a minimum differential to ensure adequate cooling of the motor (if the pump is a canned motor pump) and lubrication of the bearings. Each of these control functions can be accomplished by a few different methods using different components.

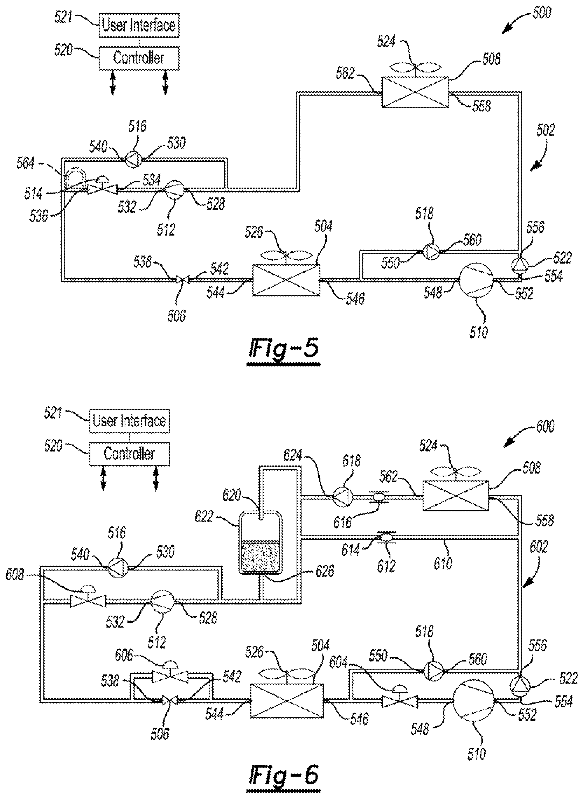

With reference to Fig. 5, an embodiment of a cooling system 500 having a pumped refrigerant economizer mode in accordance with an aspect of the present disclosure is shown. Cooling system 500 includes a DX cooling circuit 502 having an evaporator 504, expansion valve 506 (which may preferably be an electronic expansion valve but may also be a thermostatic expansion valve), condenser 508 and compressor 510 arranged in a DX refrigeration circuit. Cooling circuit 502 also includes a fluid pump 512, solenoid valve 514 and check valves 516, 518, 522. An outlet 562 of condenser 508 is coupled to an inlet 528 of pump 512 and to an inlet 530 of check valve 516. An outlet 532 of pump 512 is coupled to an inlet 534 of solenoid valve 514. An outlet 536 of solenoid valve 514 is coupled to an inlet 538 of electronic expansion valve 506. An outlet 540 of check valve 516 is also coupled to the inlet 538 of electronic expansion valve 506. An outlet 542 of electronic expansion valve 506 is coupled to a refrigerant inlet 544 of evaporator 504. A refrigerant outlet 546 of evaporator 504 is coupled to an inlet 548 of compressor 510 and to an inlet 550 of check valve 518. An outlet 552 of compressor 510 is coupled to an inlet 554 of check valve 522 and an outlet 556 of check valve 522 is coupled to an inlet 558 of condenser 508 as is an outlet 560 of check valve 518. The foregoing description corresponds to the description of Fig. 12 of USSN 13/446,310 for "Vapor Compression Cooling System with Improved Energy Efficiency Through Economization" filed April 13, 2012. The entire of disclosure of USSN 13/446,310 is incorporated herein by reference.

Cooling system 500 also includes a controller 520 coupled to controlled components of cooling system 500, such as electronic expansion valve 506, compressor 510, pump 512, solenoid valve 514, condenser fan 524, and evaporator air moving unit 526. Controller 520 is illustratively programmed with appropriate software that implements the below described control of cooling system 500. Controller 520 may include, or be coupled to, a user interface 521. Controller 520 may illustratively be an iCOM® control system available from Liebert Corporation of Columbus, Ohio programmed with software implementing the additional functions described below.

Pump 512 may illustratively be a variable speed pump but alternatively may be a fixed speed pump. Condenser fan 524 may illustratively be a variable speed fan but alternatively may be a fixed speed fan.

Where pump 512 is a variable speed pump, cooling capacity of cooling circuit 502 when in the pumped refrigerant economizer mode is controlled by controller 520 by modulating the speed of pump 512. That is, to increase cooling capacity, controller 520 increases the speed of pump 512 to increase the rate of flow of refrigerant in cooling circuit 502 and to decrease cooling capacity, controller 520 decreases the speed of pump 512 to decrease the rate of flow or refrigerant in cooling circuit 502. The refrigerant temperature at the inlet of evaporator 504 is maintained above freezing by controller 520 modulating the speed of fan 524 of condenser 508 and the minimum pump differential is maintained by controller 520 modulating the electronic expansion valve 506. Pump differential means the pressure differential across the pump. In this regard, when pump 512 is a variable speed pump, it may illustratively be a hermetically sealed pump cooled by the refrigerant that is flowing through it as it is pumping the refrigerant and thus a minimum pump differential is needed so that pump 512 is adequately cooled.

Where pump 512 is a fixed speed pump, cooling capacity of cooling circuit 502 is controlled by controller 520 modulating electronic expansion valve 506 to increase or decrease the rate of flow of refrigerant in cooling circuit 502.

In DX (compressor) mode, controller 520 controls compressor 510 to be running, solenoid valve 514 to be closed and pump 512 to be off. Since compressor 510 is running, suction at an inlet 548 of compressor 510 draws vaporized refrigerant from an outlet 546 of evaporator 504 into compressor 510 where it is compressed by compressor 510, raising its pressure. The suction at the inlet 548 of running compressor 510 will draw the refrigerant into the inlet 548 and it doesn't flow through check valve 518. The refrigerant then flows through check valve 522 into condenser 508 where it is cooled and condensed to a liquid state. Since solenoid valve 514 is closed and pump 512 is off, after the refrigerant flows out of condenser 508 it flows through check valve 516, through expansion valve 506 where its pressure is reduced and then into evaporator 504. The refrigerant flows through evaporator 504, where it is heated to vaporization by air to be cooled flowing through evaporator 504, and then back to the inlet 548 of compressor 510.

When controller 520 switches cooling circuit 502 to the pumped refrigerant economizer mode, it opens solenoid valve 514, turns compressor 510 off and pump 512 on. Pump 512 then pumps the refrigerant to circulate it and it flows through solenoid valve 514, electronic expansion valve 506, evaporator 504, check valve 518 bypassing compressor 510, through condenser 508 and back to an inlet 528 of pump 512. Controller 520 switches cooling circuit 502 to the pumped refrigerant economizer mode when the temperature of the outside air is cold enough to provide the requisite temperature differential between the inside air to be cooled and the outside air to which heat is rejected.

In an aspect, an inverted trap 564 may be coupled between outlet 536 of valve 514 and inlet 538 of electronic expansion valve 506 as shown in phantom in Fig. 5.

In an aspect, a receiver/surge tank, such as receiver/surge tank 622 described below, may be coupled between outlet 562 of condenser 508 an inlet 528 of pump [[55]] 512 so that all refrigerant flow through the receiver/surge tank prior to entering inlet 528.

Fig. 6 shows a cooling system 600 having a cooling circuit 602 that is a variation of cooling circuit 502. With the following differences, cooling system 600 is otherwise essentially the same as cooling system 500 and otherwise operates in the same manner as cooling system 500. In cooling system 600, a solenoid valve 604 is added at the inlet 548 of compressor 510 that is controlled by controller 520 to prevent liquid slugging to the compressor. When cooling system 600 is in the DX (compressor) mode, controller 520 opens solenoid valve 604. When cooling system 600 is in the pumped refrigerant economizer mode, controller 520 closes solenoid valve 604 thus preventing refrigerant from flowing to inlet 548 of compressor 510 and preventing liquid slugging of compressor 510. A bypass solenoid valve 606 is also added around electronic expansion valve 506 and a distributor (not shown) that distributes the refrigerant to the circuits of the evaporator includes an inlet port that bypasses the orifice of the distributor, and the outlet of the bypass solenoid valve 606 is plumbed to this bypass inlet to reduce system pressure drop. In cooling system 600, the pump differential is maintained by controller 520 modulating a discharge control valve 608 at discharge outlet 532 of pump 512. It should be understood that while discharge control valve 608 is shown with the same valve symbol as used for solenoid valves, discharge control valve 608 is a variable flow valve as opposed to an on-off valve. In this embodiment, pump 512 is variable speed pump and controller 520 modulates the speed of pump 512 to control a flow rate of the refrigerant being circulated to control the cooling capacity of cooling system 500 when cooling system 500 is in the pumped refrigerant economizer mode. Cooling circuit 602 of cooling system 600 also includes bypass line 610 around the condenser 508 with bypass control valve 612 in bypass line 610 to allow flow of the warm refrigerant around the condenser 508 to mix with cold refrigerant flowing from outlet 562 of condenser 508 to maintain the desired temperature and prevent evaporator freezing. Bypass control valve 612 is a variable flow valve and is illustratively controlled by controller 520. A pressure regulating valve 616 and a check valve 618 are coupled in series between outlet 562 of condenser 508 and to an inlet 620 of receiver/surge tank 622. An outlet 614 of bypass control valve 612 is also coupled to inlet 528 of pump 512 and to inlet 620 of receiver/surge tank 622, and thus also coupled to an outlet 624 of check valve 618. An outlet 626 of receiver/surge tank 622 is coupled to inlet 528 of pump 512. In the previously discussed embodiment of Fig. 5, no receiver/surge tank 622 is required because the cooling system is run in pumped refrigerant economizer mode by controller 520 with the same distribution of refrigerant as in DX (compressor) mode (liquid between the condenser and the evaporator inlet, liquid-vapor mix in the evaporator, and vapor between the evaporator outlet and the condenser inlet). With receiver/surge tank 622, controller 520 can run cooling system 600 to overfeed evaporator 504 so that there would be a liquid-vapor mix between evaporator outlet 546 and condenser 508. This increases the cooling capacity of cooling system 600 compared to the previously discussed embodiments, but the addition of receiver/surge tank 622 adds cost. It should be understood that receiver/surge tank 622 can be used with the previously discussed embodiments and doing so makes the system less charge sensitive. That is, the system can accommodate wider variations in refrigerant charge levels.

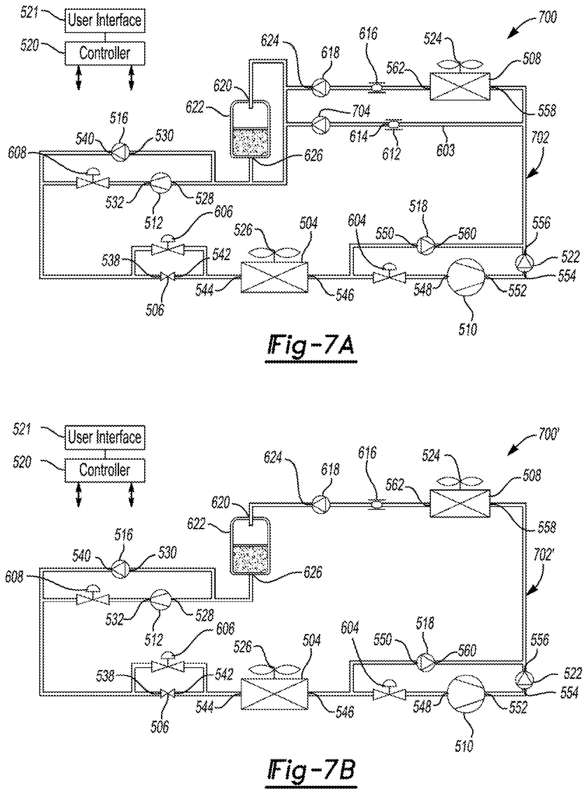

Fig. 7A shows a cooling system 700 that is a variation of cooling system 600 having a cooling circuit 702. With the following differences, cooling system 700 is otherwise essentially the same as cooling system 600 and otherwise operates in the same manner as cooling system 600. Outlet 614 of bypass control valve 612 is coupled through check valve 704 to inlet 620 of receiver/surge tank 622 and to inlet 528 of pump 512 and outlet 624 of check valve 618 is also coupled to inlet 620 of receiver/surge tank 622 and to inlet 528 of pump 512. The refrigerant preferentially flows through receiver/surge tank 622 prior to entering inlet 528 of pump 512, but may flow around receiver surge tank 622.

Fig. [[7BA]] 7B shows a cooling system 700' that is also a variation of cooling system 600 having cooling circuit 702'. Bypass control valve 612 and check valve 704 are eliminated and the outlet of check valve 618 is coupled to the inlet 620 of receiver/surge tank 622 but not to the inlet 528 of pump 512. In cooling system 700', all the refrigerant flows through receiver/surge tank 622 prior to entering inlet 528 of pump 512.

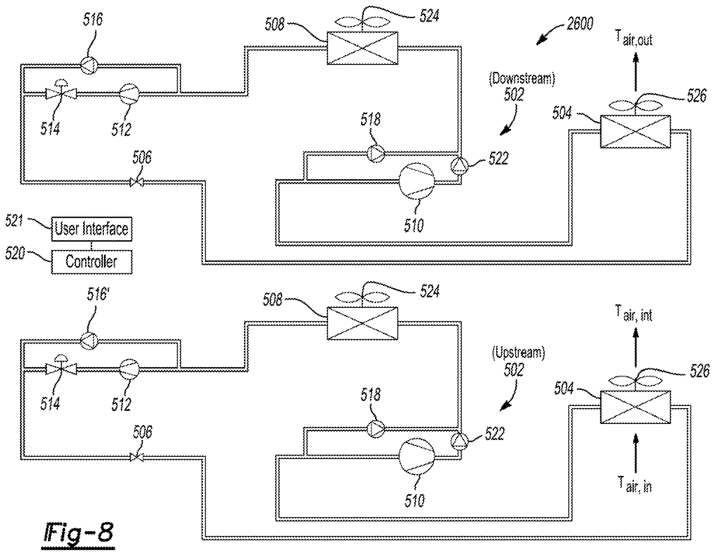

The discussions of the cooling circuits of Figs. 5, 6, 7A and 7B were based on a one circuit cooling system, or on a two circuit system in which the evaporators are parallel in the air-stream. The cooling circuits of Figs. 5, 6, 7A and 7B can also be utilized for staged cooling as described above, particularly with reference to Fig. 3, where the evaporators of the two circuits are staged in series in the air stream of air to be cooled. Because of this, the entering air temperature is higher on the upstream circuit than on the downstream circuit. Subsequently, the evaporating temperature is higher on the upstream circuit as well. So with the staged system, the upstream circuit will be able to switch over to pumped refrigerant economizer mode before the downstream cooling circuit, which could still be operating in DX (compressor) mode depending on the load. For example, two cooling circuits 502 could be arranged with their evaporators in series to provide staged cooling. Fig. 8 shows a cooling system 800 having two cooling circuits 502 arranged to provide staged cooling along the lines discussed above with regard to Fig. 3. In this embodiment, compressor 510 in each of the two cooling circuits 502 may illustratively be a tandem digital scroll compressor.

In a staged cooling system having two or more staged cooling circuits, at least the most upstream cooling circuit is a variable capacity cooling circuit and preferably the downstream cooling circuit (or circuits) is also variable capacity cooling circuits. Such variable capacity may be provided by the use of a tandem digital scroll compressor as discussed above. It can also be provided by the use of a single variable capacity compressor, such as a digital scroll compressor, a plurality of fixed capacity compressors, or other combinations of fixed and variable capacity compressors. Variable capacity is also provided by the liquid pump when the cooling circuit is a pumped refrigerant cooling circuit, or operating in the pumped refrigerant economizer mode such as cooling circuit 502 operating in the pumped refrigerant economizer mode.

The advantage to using a cooling system with staged cooling as discussed above with this pumped refrigerant economizer is that hours of operation can be gained in pumped refrigerant economizer mode on the upstream cooling circuit since it is operating at a higher evaporating temperature than either cooling circuit would be in a typical prior art parallel evaporator system. So, energy can be saved for more hours of the year. The colder the climate is, the more annual energy efficiency increase can be realized.

As has been discussed, in a typical vapor compression refrigeration system, a large percentage of system power is used to compress the refrigerant vapor leaving the evaporator, thereby increasing the condensing temperature of the refrigerant to allow for heat rejection in the condenser. As described above, particularly with reference to Fig. 5, in an aspect of the present disclosure in order to save energy in a vapor compression refrigeration system, a pump can be used to move refrigerant from the condenser to the evaporator when outdoor temperatures are low enough to provide "free" cooling without the need to compress the refrigerant vapor. Such a pumped refrigerant (economizer) system is a precision cooling system with aims of energy savings, high efficiency and optimized system performance. System control is important to achieving these objectives. More specifically, the control objectives are divided into three levels with different priorities, namely:

1. Component Safety Level: to guarantee key component safety

    i) Pump cavitation prevention - Subcooling monitoring
    ii) Ensuring pump cooling and lubrication
    iii) Evaporator coil freeze protection

2. Performance Level: to run the system functionally and flawlessly

    i) Maintain controlled air temperature to the setpoint
    ii) Proper and smooth working mode switchover
    iii) Fault detection and alarm handling

3. Optimization Level

    i) Extending economizer running hours
    ii) Advanced fault detection and diagnosis

The resources available for the system to achieve the above-listed objectives are the installed actuators, which include a variable-speed pump (e.g., pump 512 in Fig. 5), a variable-speed condenser fan (e.g., fan 524 in Fig. 5) and an electronic expansion valve (EEV) (e.g., EEV 506 in Fig. 5). The first step of the control design is to work out a control strategy to decide how to allocate the resources to different control tasks. In other words, given that the entire economizer system is a multi-input multi-output system (with multiple actuators and multiple variables to be controlled), how to decouple the system and determine the input-output relationship is the solution that the following control strategy implements. This control strategy is summarized on a high level basis as follows:

• Manipulate the condenser fan to control the refrigerant temperature leaving the condenser;
• Manipulate the pump to control system capacity, and ultimately the air temperature in the controlled space;
• Manipulate the EEV to control pressure differential across the pump.

The multi-input and multi-output pumped refrigerant economizer system is controlled in a relatively simple way. The system is decoupled into three feedback control loops which regulate their controlled variables by manipulating their corresponding control inputs as follows:
The aforementioned control strategy benefits the system in several ways:

1. The condenser fan controls the refrigerant temperature to a setpoint such that"

    a. Refrigerant temperature will not be low enough to freeze the evaporator coil;
    b. Subcooling is maximized to prevent pump cavitation;
    c. Condenser fan speed is optimized to save energy in the sense that the fan speed can't be further reduced without compromising subcooling and cooling capacity.

2. The pump speed controls refrigerant flow rate, and the capacity in turn, by controlling the room's air temperature to the user given setpoint.

    a. Pump speed is roughly linear with respect to capacity for a fixed refrigerant temperature, which is maintained by the condenser fan speed control.
    b. Linearity facilitates high control precision of the air temperature in the controlled space.

3. The EEV controls the differential pressure across the pump such that

    a. The pump motor is sufficiently cooled;
    b. The pump bearings are sufficiently lubricated.

The entire system energy consumption is optimized by the foregoing control strategy in the sense that no further energy consumption can be realized without sacrificing cooling performance.

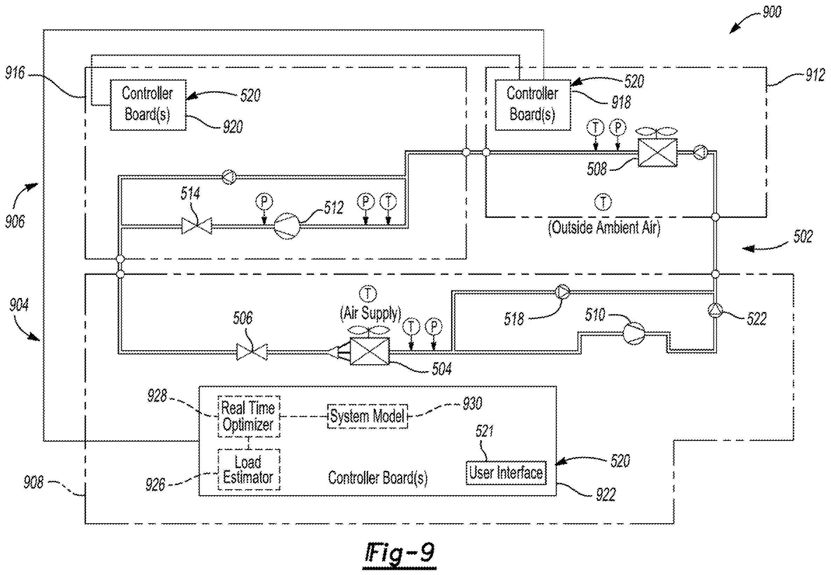

Fig. 9 is a schematic of a cooling system 900 having one cooling circuit 502 having a DX cooling circuit 904 and a pumped refrigerant economizer circuit 906. Cooling system 900 may physically consist of three units: an indoor unit 908 (illustratively a computer room air conditioner), a pumped refrigerant economizer unit 916, and an air-cooled condenser unit 912. The indoor unit 908 is located inside the room to be cooled, such as a data center room, and contains the major components of the DX cooling circuit (other than the condenser 508), including the evaporator 504, compressor 510, and expansion valve 506, etc. The indoor unit's 908 functionality is to operate the system in a standard direct expansion mode, and also drive the valves needed to run the system in pumped refrigerant economizer mode. The pumped refrigerant economizer unit 916 is located outside the room and contains the major components including pump 512, etc. The pumped refrigerant economizer unit 916 uses liquid pump 512 to move refrigerant from the condenser 508 to the evaporator 504 when the outdoor temperatures are low enough to provide "free" cooling without running a direct expansion refrigeration system. The condenser unit 912 is also located outside the room to be cooled but separated from the pumped refrigerant economizer unit 916. It cooperates with one of the other two units 908, 916 according to heat rejection demand. In Fig. 9, "T" in a circle is a temperature sensor and "P" in a circle is a pressure sensor, in each instance that are coupled to controller 520, such as to a respective one of controller boards 918, 920, 922 (which are discussed below). The temperature sensors include an outside ambient air temperature sensor (shown adjacent condenser 508) and a supply air (or room return air) temperature sensor (shown adjacent evaporator 504). The remaining temperature sensors sense temperatures of the refrigerant at the indicated locations of cooling circuit 502 and the pressure sensors sense the pressures of the refrigerant at the indicated locations of cooling circuit 502.

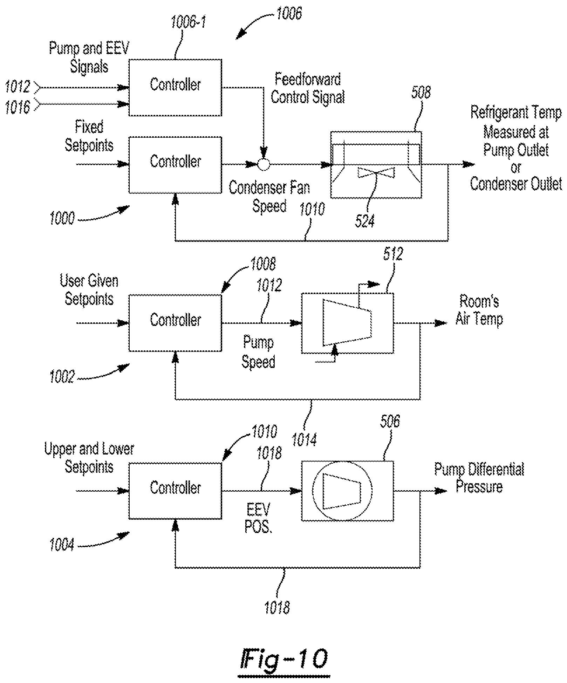

When the cooling system 900 operates in pumped refrigerant economizer mode, there are three feedback control loops for the basic control of the pumped refrigerant economizer mode, as shown in Fig. 10.

A refrigerant temperature feedback control loop 1000 controls the refrigerant temperature to a setpoint by regulating the condenser fan speed. The refrigerant temperature is measured at the pump outlet or at the condenser outlet. In an aspect, the setpoint is set in the range of 37°F to 42°F. It should be understood that these values are exemplar and the fixed setpoint can be other than 37°F to 42°F. It should also be understood that the setpoint can be inputted manually, such as by a user, or determined by a controller such as controller 520.

A room air temperature feedback control loop 1002 controls the room's air temperature to the setpoint entered by a user, such as into controller 520, by regulating the pump speed.

An liquid pump differential pressure feedback control loop 1004 maintains the liquid pump differential pressure (PSID) within a given range by regulating the EEV 506 opening. In an aspect, the given range is set to be 20 PSID to 25 PSID. The given range is determined by its upper and lower setpoints. It should be understood that these values are exemplar and the given range can be other than 20 PSID to 25 PSID. It should also be understood that that the given range could be input by a user.

Each control loop 1000, 1002, 1004 may illustratively be a process control type of control loop, and may preferably be a PID loop. In the embodiment shown in Fig. 10, each control loop 1000, 1002, 1004 is shown implemented with a separate controller 1006, 1008, 1010, respectively, such as to co-locate a respective controller board(s) 918, 920, 922 (Fig. 9) having each controller 1006, 1008, 1010 in proximity to the device it is controlling, and controllers 1006, 1008, 1010 communicate with each other, such as via a controller area network (CAN) bus. For example, the controller board(s) 918 having controller 1006 is located in proximity to condenser 508 in that controller 1006 controls the speed of condenser fan 524. The controller board 920 having controller 1008 is located in proximity to pump 512 in that controller 1008 controls the speed of pump 512. The controller board(s) 922 having controller 1010 is collocated in proximity to EEV 506 in that controller 1010 controls the position of EEV 506. While controllers 1006, 1008, 1010 are implemented on separately located controller boards in this embodiment, controllers 1006, 1008 and 1010 are collectively considered part of controller 520. It should be understood that control loops 1000, 1002 and 1004 could be implemented on a controller board(s) at a single location along with the remainder of the control functions of controller 520.

Refrigerant temperature feedback control loop 1000 has an output at which a condenser fan speed control signal is output and has as inputs the refrigerant temperature setpoint and a feedback signal which is the actual refrigerant temperature, such as by way of example and not of limitation, at the outlet of the condenser. The room air temperature feedback control loop 1002 has an output at which a liquid pump speed control signal is output and has as inputs the room air temperature setpoint and a feedback signal which is the actual room air temperature, such as by way of example and not of limitation, at the return air inlet of the cooling system. The liquid pump pressure differential control feedback loop 1004 has an output at which an electronic expansion valve position signal is output and having as inputs the given range and a feedback signal which is a pressure differential across the liquid pump.

In order to further improve the transient performance of the refrigerant temperature control (which is controlled by controlling the speed of condenser fan 524 by control loop 1000), a feedforward controller (controller 1006-1 in Fig. 10) is applied to stabilize refrigerant temperature by using the pump speed control signal 1012 from controller 1008 and the EEV control signal 1018 from controller 1010 as its inputs. The rationale is that refrigerant temperature is related to the flow rate that can be estimated by the pump speed and EEV opening. The outputs 1012, 1018 of controllers 1008 and 1010 of Fig. 10 are fed forward to the condenser fan speed control loop 1000. The condenser fan speed signal consists of two parts: feedback signal and feedforward signal. Thus, the condenser fan can respond by being driven by the feedforward signal in advance of the feedback signal coming back.

The three control loops have different magnitudes of response time, which prevents the situation in which multiple control elements can interact to create instability in the control.

This control strategy applies to the pumped refrigerant economizer system particularly and can also be applied to the class of cooling or air conditioning systems with pumped refrigerant circulation.

The foregoing description of cooling system 900 is based on a cooling system having one cooling circuit. A similar control strategy can be applied to cooling systems having two cooling circuits, such as those arranged to provide staged cooling as discussed above. For a cooling system having two cooling circuits, such as having staged cooling with two cooling circuits, the condenser fan and EEV in the second circuit perform the same respective control tasks as in the first circuit. The cooling capacity is controlled by the aggregate pump speeds. A control algorithm, an example of which is discussed below, determines the capacity contributed by each pump, and hence decides each pump's speed.

As discussed, when the cooling system is in the pumped refrigerant economizer mode, there are three main controlled parameters: room temperature, refrigerant temperature and pump pressure differential (outlet pressure minus inlet pressure). The room temperature is controlled by modulating the pump speed via a variable frequency drive. In a cooling system having staged cooling with two or more cooling circuits, when the cooling system is in the pumped refrigerant economizer mode, the cooling load requirement will determine if the pump in one or more than one of the cooling circuits needs to be operated.

In an illustrative embodiment, controller 520 switches the cooling system, such as cooling system 800, to the pumped refrigerant economizer mode when there is either a minimum difference between the room return air temperature entering the cooling system and the outdoor air temperature or the outdoor air temperature is below a minimum (such as below 35°F in the example below). In an aspect, the lower of the actual room return air temperature and the setpoint is used for the comparison. In an aspect, the minimum temperature difference between the room return air is 45°F and the minimum outside air temperature is 35°F. It should be understood that these temperatures are examples and minimum temperature difference other than 45°F and a minimum outside air temperature other than 35°F can be used. As discussed above, in an aspect, the cooling circuits in a system having staged cooling may be controlled separately in which case the room air temperature used for the comparison for each cooling circuit may be the actual room return air temperature (or its setpoint if lower) entering the evaporator 504 of that cooling circuit 502.

In an aspect, controller 520 will switch the cooling system from pumped refrigerant economizer mode to direct expansion mode when the pumped refrigerant economizer mode is not keeping up with the cooling demand. In the event that the cooling system has staged cooling, in an aspect controller 520 will first switch the most downstream cooling circuit from the pumped refrigerant economizer mode to direct expansion mode and if this fails to provide sufficient cooling, then successively switches each next upstream cooling circuit in turn to the direct expansion mode.

In an aspect, controller 520 also switches each cooling circuit from the pumped refrigerant economizer mode to the direct expansion mode should the pump differential pressure of the pump 512 of that cooling circuit fall below a predetermined minimum for a predetermined period of time. This prevents pump failure due to insufficient pump differential pressure.

In an aspect, controller 520 also switches each cooling circuit from the pumped refrigerant economizer rode to the direct expansion mode if the temperature of the refrigerant leaving the pump of that cooling circuit falls below a predetermined temperature for a predetermined period of time.

In an aspect, controller 520 may also switch each cooling circuit from the pumped refrigerant economizer mode to the direct expansion mode in the event of a condition indicating a failure of the pumped refrigerant economizer mode, such as loss of power to the pump.

In an aspect, the controller includes a real-time load estimator 926 (shown in phantom in Fig. 9) that estimates real-time indoor heat load on the cooling system and uses the estimated real-time indoor heat load to determine whether to operate the cooling system in the pumped refrigerant economizer mode or in the direct expansion mode. In an aspect, the load estimator calculates the real-time indoor heat load based on the indoor return air temperature (for example, the temperature of the room air at the return air inlet of the CRAC], the supply air temperature (for example, the temperature of the cooled air exiting the CRAC) and the volume of air flow across the evaporator. It may for example do so using the following equation (implemented in software) in the controller:

$$\dot{Q}_{sensible} = \%_{fan\ speed} \times \dot{m}_{@100\%\ fan\ speed} \times c_p \times (T_{return\ air} - T_{supply\ air})$$

where $\dot{m}$ is the mass flow rate of the air flowing across the evaporator, and $c_p$ is the molar heat capacity at a constant pressure of the air flowing across the evaporator.

In an aspect, if supply air temperature or return air temperature is not available, the load estimator uses compressor loading information instead. In an aspect, compressor loading is determined by

$$max[CFC,\ 20\%]*M_{CAP}$$

where CFC is the call for cooling and $M_{CAP}$ is the maximum capacity coefficient of the compressor determined from a 2D lookup table, whose inputs are the indoor control temperature and the outdoor temperature. CFC is the actual cooling that the cooling system is being called on to provide, typically expressed as a percentage of the overall or nominal maximum cooling capacity of the cooling system.

The capacity of the cooling system, such as any of cooling systems 500, 600, 700, 700', is a function of the difference between the indoor return air temperature (referred to as "indoor temperature") and outdoor temperature. Controller 520 obtains the current real-time load information of the cooling system from its real time load estimator 926. Given the condition of the indoor temperature, outdoor temperature and real-time load information, controller 520 determines whether it is feasible to run the cooling system in the pumped refrigerant economizer mode. For example, if the cooling system is able to reach a full capacity of 125kW at a 40 degF difference between indoor and outdoor temperature, the current indoor temperature is controlled to a set point of 80 degF and the load is 50% (62.5kW), controller 520 determines that the cooling system can be operated in the pumped refrigerant economizer mode when the outdoor temperature is 60 degF or below. A simplistic control equation for the foregoing is:

$$Outdoor\ Temp. = Indoor\ Temp.\ Setpoint - (\%Load \times Max\ Temp\ Diff.)$$

Where Outdoor Temp. is the outdoor temperature at or below which the cooling system can be run in the pumped refrigerant economizer mode, Indoor Temp. Setpoint is the setpoint for the indoor temperature, %Load is the real-time indoor load on the cooling system (that may be estimated as discussed above) as a percent of the maximum load of the cooling system, and Max. Temp. Diff is the temperature difference between indoor temperature and outdoor temperature at which the pumped refrigerant economizer can be operated to provide full capacity.

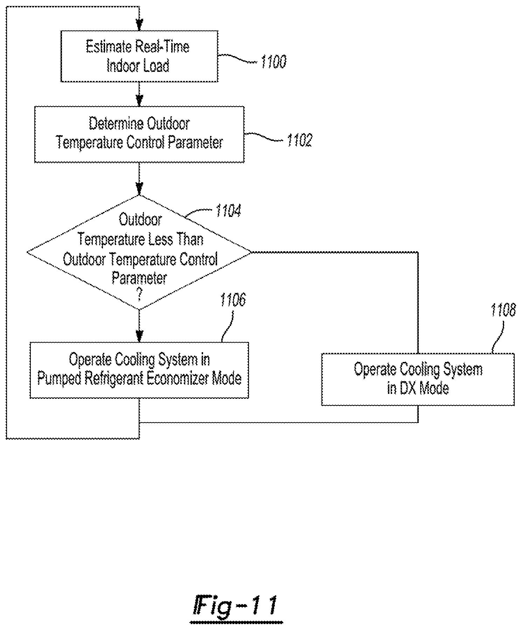

Fig. 11 is a basic flow chart for a software routine for control of the cooling system utilizing the real time load estimator 926, and may illustratively be part of the software of controller 520. At 1100, controller 520 estimates real time indoor load as described above. At 1102, controller 520 determines the Outdoor Temp. control parameter based on the above control equation. At 1104, controller 520 checks whether the actual outdoor temperature is below the Outdoor Temp. control parameter. If so, at 1106 controller 520 operates the cooling system in the pumped refrigerant economizer mode. If not, at 1108 controller 520 operates the cooling system in the DX mode.

It should be understood that in cooling systems having a plurality of cooling circuits each with a pumped refrigerant economizer mode and a DX mode, the controller makes the above determination for each cooling circuit as to the outdoor air temperature at or below that cooling circuit can be operated in the pumped refrigerant economizer mode.

Spatially relative terms, such as "inner," "outer," "beneath", "below", "lower", "above", "upper" and the like, may be used herein for ease of description to describe one element or feature's relationship to another element(s) or feature(s) as illustrated in the figures. Spatially relative terms may be intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

As used herein, the term controller, control module, control system, or the like may refer to, be part of, or include an Application Specific Integrated Circuit (ASIC); an electronic circuit; a combinational logic circuit; a field programmable gate array (FPGA); a processor (shared, dedicated, or group) that executes code; a programmable logic controller, programmable control system such as a processor based control system including a computer based control system, a process controller such as a PID controller, or other suitable hardware components that provide the described functionality or provide the above functionality when programmed with software as described herein; or a combination of some or all of the above, such as in a system-on-chip. The term module may include memory (shared, dedicated, or group) that stores code executed by the processor.

The term software, as used above, may refer to computer programs, routines, functions, classes, and/or objects and may include firmware, and/or microcode.

The apparatuses and methods described herein may be implemented by software in one or more computer programs executed by one or more processors of one or more controllers. The computer programs include processor-executable instructions that are stored on a non-transitory tangible computer readable medium. The computer programs may also include stored data. Non-limiting examples of the non-transitory tangible computer readable medium are nonvolatile memory, magnetic storage, and optical storage.

The foregoing description of the embodiments has been provided for purposes of illustration and description. It is not intended to be exhaustive or to limit the invention.

**Claims**

1. A cooling system (102), comprising:

    a cabinet (202) having an air inlet and an air outlet;
    a cooling circuit (301) that includes an evaporator (312) disposed in the cabinet, a condenser (316), a compressor (318), an expansion device (314) and a liquid pump;
    the cooling system having a direct expansion mode wherein the compressor is on and compresses a refrigerant in a vapor phase to raise its pressure and thus its condensing temperature and refrigerant is circulated around the cooling circuit by the compressor and a pumped refrigerant economizer mode wherein the compressor is off and the liquid pump is on and pumps the refrigerant in a liquid phase and refrigerant is circulated around the cooling circuit by the liquid pump and without compressing the refrigerant in its vapor phase;
    a controller (320) coupled to the liquid pump and the compressor that turns the compressor off and the liquid pump on to operate the cooling circuit in the economizer mode and turns the compressor on to operate the cooling circuit in the direct expansion mode; and
    the controller including a load estimator (926) that estimates real-time indoor load on the cooling system and uses the estimated real-time indoor load to determine whether to operate the cooling system in the pumped refrigerant economizer mode or in the direct expansion mode.

2. The cooling system of claim 1 wherein the load estimator calculates the real-time indoor load based on a temperature of indoor return air, a temperature of supply air and a volume of air flow across the evaporator.

3. The cooling system of claim 2 wherein if the temperature of the supply air or temperature of the return air is not available, the load estimator uses compressor loading information instead of the temperature of the supply air or temperature of the return air.

4. The cooling system of claim 1 including a receiver/surge tank (622) coupled between the condenser and the liquid pump.

5. The cooling system of claim 1 wherein the controller further determines an outdoor temperature at or below which the cooling system can be operated in the pumped refrigerant economizer mode and operates the cooling system in the pumped refrigerant economizer mode when the outdoor air temperature is at or below that determined outdoor air temperature.

6. The cooling system of claim 1 further including a second cooling circuit having an evaporator disposed in the cabinet, a condenser, a compressor, an expansion device and a liquid pump with one cooling circuit included in an upstream cooling stage and one cooling circuit included in a downstream cooling stage wherein the evaporator of the cooling circuit of the upstream cooling stage (upstream evaporator) and the evaporator of the cooling circuit of the downstream cooling stage (downstream evaporator) are arranged in the cabinet so that air to be cooled passes over them in serial fashion, first over the upstream evaporator and then over the downstream evaporators, the cooling circuit of each cooling stage operable in the direct expansion mode and the pumped refrigerant economizer mode wherein the compressor of that cooling circuit is off and the liquid pump of that cooling circuit is on and the refrigerant is circulated around the cooling circuit by the liquid pump of that cooling circuit.

7. The cooling system of claim 6 wherein when one of the upstream and downstream cooling stages can be in the pumped refrigerant economizer mode and the other must be in the direct expansion mode, the controller operates the cooling circuit of the upstream cooling stage in the pumped refrigerant economizer mode turning the liquid pump of that cooling circuit on and the compressor of that cooling circuit off and operates the downstream cooling stage in the direct expansion mode turning the compressor of the downstream cooling circuit on.

8. The cooling system of claim 1 wherein the controller further determines an outdoor temperature at or below which each cooling circuit can be operated in the in the pumped refrigerant economizer mode and operates each cooling circuit in the pumped refrigerant economizer mode when the outdoor air temperature is at or below the determined outdoor air temperature for that cooling circuit.

**Patentansprüche**

1. Kühlsystem (102), umfassend:

einen Kasten (202) mit einem Lufteinlass und einem Luftauslass;
einen Kühlkreislauf (301), der einen Verdampfer (312), der in dem Kasten angeordnet ist, einen Kondensator (316), einen Kompressor (318), eine Ausdehnungsvorrichtung (314) und eine Flüssigkeitspumpe enthält;
wobei das Kühlsystem einen direkten Ausdehnungsmodus, wobei der Kompressor an ist und ein Kältemittel in einer Dampfphase komprimiert, um dessen Druck und damit dessen Kondensationstemperatur zu erhöhen, und Kältemittel durch den Kompressor in dem Kühlkreislauf umgewälzt wird, und einen Modus mit Rationalisierung eines gepumpten Kältemittels, wobei der Kompressor aus und die Flüssigkeitspumpe an ist und das Kältemittel in einer Flüssigkeitsphase pumpt und Kältemittel durch die Flüssigkeitspumpe in dem Kühlkreislauf umgewälzt wird, und ohne das Kältemittel in seiner Dampfphase zu komprimieren, aufweist;
eine Steuerung (320), die mit der Flüssigkeitspumpe und dem Kompressor verbunden ist, die den Kompressor aus- und die Flüssigkeitspumpe anschaltet, um den Kühlkreislauf in dem Rationalisierungsmodus zu betreiben, und den Kompressor anschaltet, um den Kühlkreislauf in dem direkten Ausdehnungsmodus zu betreiben; und
wobei die Steuerung eine Belastungsschätzeinrichtung (926) enthält, die eine Echtzeit-Innenbelastung auf das Kühlsystem schätzt und die geschätzte Echtzeit-Innenbelastung nutzt, um zu ermitteln, ob das Kühlsystem in dem Modus mit Rationalisierung eines gepumpten Kältemittels oder in dem direkten Ausdehnungsmodus betrieben werden soll.

2. Kühlsystem nach Anspruch 1, wobei die Belastungsschätzeinrichtung die Echtzeit-Innenbelastung anhand einer Innenrücklufttemperatur, einer Zulufttemperatur und eines Luftstromvolumens über dem Verdampfer berechnet.

3. Kühlsystem nach Anspruch 2, wobei die Belastungsschätzeinrichtung Kompressorlast-Informationen anstelle der Zulufttemperatur oder der Rücklufttemperatur nutzt, wenn die Zulufttemperatur oder Rücklufttemperatur nicht verfügbar ist.

4. Kühlsystem nach Anspruch 1, das einen Aufnahme-/Ausgleichsbehälter (622) enthält, der zwischen den Kondensator und die Flüssigkeitspumpe gekoppelt ist.

5. Kühlsystem nach Anspruch 1, wobei die Steuerung ferner eine Außentemperatur ermittelt, bei der oder unter der das Kühlsystem in dem Modus mit Rationalisierung eines gepumpten Kältemittels betrieben werden kann, und das Kühlsystem in dem Modus mit Rationalisierung eines gepumpten Kältemittels betreibt, wenn die Außenlufttemperatur gleich oder unter jener ermittelten Außenlufttemperatur ist.

6. Kühlsystem nach Anspruch 1, das ferner einen zweiten Kühlkreislauf mit einem Verdampfer, der in dem Kasten angeordnet ist, einem Kondensator, einem Kompressor, einer Ausdehnungsvorrichtung und einer Flüssigkeitspumpe enthält, wobei ein Kühlkreislauf in einer vorgelagerten Kühlstufe und ein Kühlkreislauf in einer nachgelagerten Kühlstufe enthalten ist, wobei der Verdampfer des Kühlkreislaufs der vorgelagerten Kühlstufe (vorgelagerter Verdampfer) und der Verdampfer des Kühlkreislaufs der nachgelagerten Kühlstufe (nachgelagerter Verdampfer) so in dem Kasten angeordnet sind, dass Luft, die gekühlt werden soll, nacheinander über sie strömt, zuerst über den vorgelagerten Verdampfer und dann über die nachgelagerten Verdampfer, wobei der Kühlkreislauf jeder Kühlstufe in dem direkten Ausdehnungsmodus und dem Modus mit Rationalisierung eines gepumpten Kältemittels betriebsfähig ist, wobei der Kompressor jenes Kühlkreislaufs aus ist und die Flüssigkeitspumpe jenes Kühlkreiskaufs an ist und das Kältemittel durch die Flüssigkeitspumpe jenes Kühlkreislaufs in dem Kühlkreislauf umgewälzt wird.

7. Kühlsystem nach Anspruch 6, wobei, wenn eine der vorgelagerten und nachgelagerten Kühlstufen in dem Modus mit Rationalisierung eines gepumpten Kältemittels sein kann und die andere in dem direkten Ausdehnungsmodus sein muss, die Steuerung den Kühlkreislauf der vorgelagerten Kühlstufe in dem Modus mit Rationalisierung eines gepumpten Kältemittels betreibt und die Flüssigkeitspumpe jenes Kühlkreislaufs anschaltet und den Kompressor jenes Kühlkreislaufs ausschaltet und die nachgelagerte Kühlstufe in dem direkten Ausdehnungsmodus betreibt und den Kompressor des nachgelagerten Kühlkreislaufs anschaltet.

8. Kühlsystem nach Anspruch 1, wobei die Steuerung ferner eine Außentemperatur ermittelt, bei der oder unter der jeder Kühlkreislauf in dem Modus mit Rationalisierung eines gepumpten Kältemittels betrieben werden kann, und jeden Kühlkreislauf in dem Modus mit Rationalisierung eines gepumpten Kältemittels betreibt, wenn die Außenlufttemperatur gleich oder unter der ermittelten Außenlufttemperatur für jenen Kühlkreislauf ist.

**Revendications**

1. Système de refroidissement (102), comprenant :

une armoire (202) ayant un orifice d'entrée d'air et un orifice de sortie d'air ;
un circuit de refroidissement (301) qui comprend un évaporateur (312) disposé dans l'armoire, un condensateur (316), un compresseur (318), un dispositif de détente (314) et une pompe de liquide ;
le système de refroidissement ayant un mode de détente directe dans lequel le compresseur est mis en marche et comprime un fluide frigorigène dans une phase vapeur pour augmenter sa pression et, donc, sa température de condensation et le fluide frigorigène est mis en circulation autour du circuit de refroidissement par le compresseur, et un mode économiseur de fluide frigorigène pompé dans lequel le compresseur est arrêté et la pompe de liquide est mise en marche et pompe le fluide frigorigène dans une phase liquide et le fluide frigorigène est mis en circulation autour du circuit de refroidissement par la pompe de liquide et sans comprimer le fluide frigorigène dans sa phase vapeur ;
un dispositif de commande (320) couplé à la pompe de liquide et au compresseur qui arrête le compresseur et met en marche la pompe de liquide pour faire fonctionner le circuit de refroidissement en mode économiseur et met en marche le compresseur pour faire fonctionner le circuit de refroidissement en mode de détente directe ; et
le dispositif de commande comprenant un estimateur de charge (926) qui estime une charge intérieure en temps réel sur le système de refroidissement et utilise la charge intérieure en temps réel qui a été estimée, pour déterminer s'il convient de faire fonctionner le système de refroidissement dans le mode économiseur de fluide frigorigène pompé ou dans le mode de détente directe.

2. Système de refroidissement selon la revendication 1, dans lequel l'estimateur de charge calcule la charge intérieure en temps réel en se basant sur une température d'air de retour intérieur, une température d'air fourni et un volume de flux d'air à travers l'évaporateur.

3. Système de refroidissement selon la revendication 2, dans lequel, si la température de l'air fourni ou la température de l'air de retour n'est pas disponible, l'estimateur de charge utilise des informations de chargement de compresseur au lieu de la température de l'air fourni ou de la température de l'air de retour.

4. Système de refroidissement selon la revendication 1, comprenant un récepteur/réservoir intermédiaire (622) couplé entre le condensateur et la pompe de liquide.

5. Système de refroidissement selon la revendication 1, dans lequel le dispositif de commande détermine en outre une température extérieure à laquelle, ou en dessous de laquelle, le système de refroidissement peut être mis en fonctionnement dans le mode économiseur de fluide frigorigène pompé lorsque la température d'air extérieur est égale ou inférieure à cette température d'air extérieur déterminée.

6. Système de refroidissement selon la revendication 1, comprenant en outre un second circuit de refroidissement ayant un évaporateur disposé dans l'armoire, un condensateur, un compresseur, un dispositif de détente et une pompe de liquide, un circuit de refroidissement étant inclus dans un étage de refroidissement amont et un circuit de refroidissement étant inclus dans un étage de refroidissement aval, dans lequel l'évaporateur du circuit de refroidissement de l'étage de refroidissement amont (l'évaporateur amont) et l'évaporateur du circuit de refroidissement de l'étage de refroidissement aval (l'évaporateur aval) sont agencés dans l'armoire de telle sorte que l'air qui doit être refroidi, passe sur eux en série, d'abord sur l'évaporateur amont et, ensuite, sur l'évaporateur aval, le circuit de refroidissement de chaque étage de refroidissement pouvant être mis en fonctionnement dans le mode de détente directe et le mode économiseur de fluide frigorigène pompé dans lequel le compresseur de ce circuit de refroidissement est arrêté et la pompe de liquide de ce système de refroidissement est mise en marche et le fluide frigorigène est mis en circulation autour du circuit de refroidissement par la pompe de liquide de ce circuit de refroidissement.

7. Système de refroidissement selon la revendication 6, dans lequel, lorsque l'un des étages de refroidissement amont et aval peut être dans le mode économiseur de fluide frigorigène pompé et que l'autre étage doit être dans le mode de détente directe, le dispositif de commande fait fonctionner le circuit de refroidissement de l'étage de refroidissement amont dans le mode économiseur de fluide frigorigène pompé mettant en marche la pompe de liquide de ce circuit de refroidissement et arrêtant le compresseur de ce circuit de refroidissement et fait fonctionner l'étage de refroidissement aval dans le mode de détente directe mettant en marche le compresseur du circuit de refroidissement aval.

8. Système de refroidissement selon la revendication 1, dans lequel le dispositif de commande détermine en outre une température extérieure à laquelle, ou en dessous de laquelle, chaque circuit de refroidissement peut être mis en fonctionnement dans le mode économiseur de fluide frigorigène pompé et fait fonctionner chaque circuit de refroidissement dans le mode économiseur de fluide frigorigène pompé lorsque la température d'air extérieur est égale ou inférieure à cette température d'air extérieur déterminée pour ce circuit de refroidissement.

Fig – 1
PRIOR ART

**Fig-2**

*PRIOR ART*

_Fig-3_

EP 2 917 649 B1

Fig-4

_Fig-5_

_Fig-6_

_Fig-7A_

_Fig-7B_

*Fig-8*

EP 2 917 649 B1

Fig-9

*Fig-10*

Estimate Real-Time
Indoor Load —————— 1100

Determine Outdoor
Temperature Control Parameter —————— 1102

Outdoor —————— 1104
Temperature Less Than
Outdoor Temperature Control
Parameter
?

Operate Cooling System in
Pumped Refrigerant Economizer Mode —— 1106

Operate Cooling System
in DX Mode —— 1108

_Fig-11_

**EP 2 917 649 B1**

**Patent documents cited in the description**

- EP 2389056 A
- US 4606198 A
- JP 12388102 B
- JP 13446310 B